# EUROPÄISCHE PATENTSCHRIFT

(11) **EP 1 446 831 B1**
(45) Veröffentlichungstag und Bekanntmachung des Hinweises auf die Patenterteilung: **22.07.2009**
(21) Anmeldenummer: 02774312.9
(22) Anmeldetag: 09.09.2002
(51) Int. Cl.: H01L 21/768

(54) **VERFAHREN ZUR HERSTELLUNG DÜNNER METALLHALTIGER SCHICHTEN MIT GERINGEM ELEKTRISCHEN WIDERSTAND**
METHOD FOR PRODUCING THIN METAL-CONTAINING LAYERS HAVING A LOW ELECTRICAL RESISTANCE
PROCEDE POUR LA PRODUCTION DE COUCHES MINCES CONTENANT DU METAL ET PRESENTANT UNE RESISTANCE ELECTRIQUE FAIBLE

(30) Priorität: 07.11.2001 DE 10154500
(43) Veröffentlichungstag der Anmeldung: 18.08.2004
(73) Patentinhaber: Infineon Technologies AG, 81669 München (DE)
(72) Erfinder: BARTH, Hans-Joachim, 81245 München (DE)
(74) Vertreter: Karl, Frank
(86) Internationale Anmeldenummer: PCT/DE2002/003344
(87) Internationale Veröffentlichungsnummer: WO 2003/041144

(56) Entgegenhaltungen:
- US-B1- 6 218 302
- US-B1- 6 228 768
- US-B1- 6 242 808

## Beschreibung

Die vorliegende Erfindung bezieht sich auf ein Verfahren zur Herstellung dünner metallhaltiger Schichten mit geringem elektrischen Widerstand und insbesondere auf dünne Cu-Leiterbahnen zur Verwendung in Halbleiterbauelementen.

Bisher wurden bei der Herstellung von integrierten Halbleiterschaltungen vorzugsweise Aluminiumschichten in jeweiligen Verdrahtungsebenen zur Realisierung von Leiterbahnen abgeschieden und strukturiert, wobei grundsätzlich eine Al-Schicht bis zu einer vorbestimmten Zieldicke abgeschieden und anschließend mittels herkömmlicher fotolithografischer und dazugehöriger Ätzverfahren strukturiert wurde.

Zunehmend werden jedoch alternative Materialien insbesondere zur Verwendung in derartigen Metallisierungsschichten eingesetzt, um der zunehmenden-Integrationsdichte gerecht zu werden. Durch die Verwendung von beispielsweise Kupfer für derartige Verdrahtungsebenen konnten auf Grund der wesentlich geringeren Widerstände gegenüber Aluminium integrierte Schaltungen entwickelt werden, die bei wesentlich höheren Geschwindigkeiten und bei einem geringeren Leistungsverbrauch arbeiten. Nachteilig ist jedoch bei der Verwendung von derartigen alternativen Materialien, insbesondere bei Kupfer, die relativ schwere Handhabbarkeit, die sich beispielsweise aus Abscheide- und/oder Ätzproblemen ergibt.

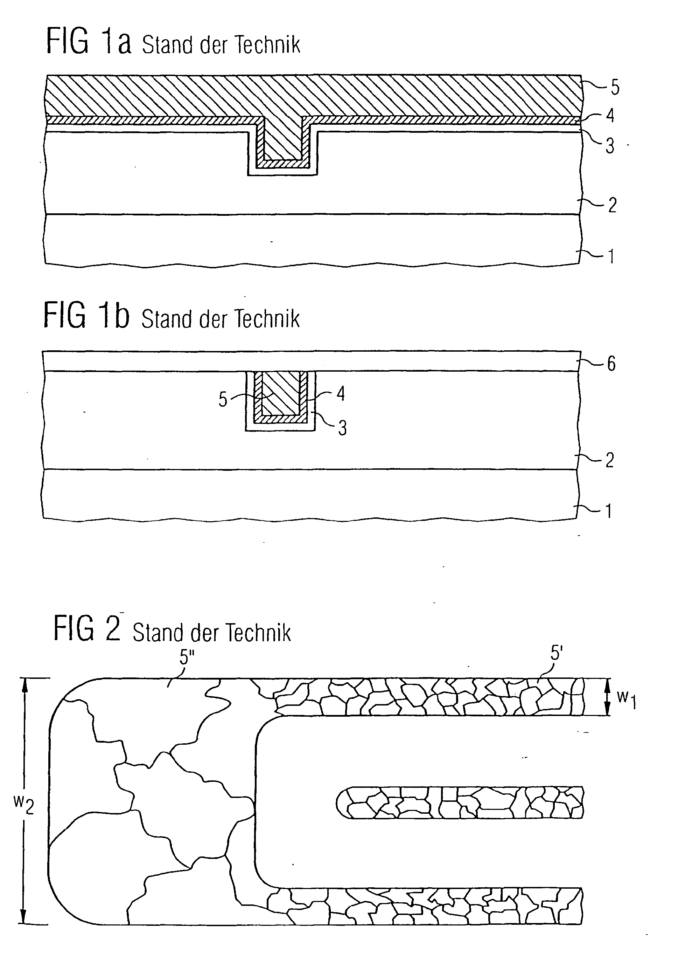

Zur Beseitigung derartiger Probleme wurde beispielsweise die in Figuren 1a und 1b dargestellte Damascene-Technologie entwickelt.

Die Figuren 1a und 1b zeigen vereinfachte Schnittdarstellungen zur Veranschaulichung wesentlicher Herstellungsschritte eines derartigen herkömmlichen Verfahrens zur Ausbildung dünner metallhaltiger Schichten.

Gemäß Figur 1a wird auf einem Trägermaterial 1, welches beispielsweise eine integrierte Halbleiterschaltung in einem Halbleitersubstrat mit darüber liegenden Elementschichten darstellt, eine dielektrische Schicht 2 abgeschieden und darin ein Graben für die später auszubildende Leiterbahn ausgebildet. In nachfolgenden Schritten wird sowohl an der Oberfläche als auch im Graben der dielektrischen Schicht 2 eine Diffusionsbarrierenschicht 3 und eine Keimschicht 4 ausgebildet, die ein nachfolgendes Aufwachsen einer Cu-Schicht 5 ermöglicht bzw. vereinfacht.

Gemäß Figur 1b wird nachfolgend beispielsweise mittels eines CMP-Verfahrens (chemical mechanical polishing) die oberhalb des Grabens verbleibende Schichtenfolge entfernt und eine weitere Diffusionsbarrierenschicht 6 als sogenannter caplayer ausgebildet.

Auf diese Weise können auch sehr fein strukturierte Leiterbahnen mit schwierig handhabbaren Materialien hergestellt werden. Nachteilig ist hierbei jedoch insbesondere bei Strukturgrößen kleiner 0,2 Mikrometer eine wesentliche Verschlechterung der elektrischen Leitfähigkeit auf Grund von Korngrößenproblemen innerhalb der metallhaltigen Schicht.

Figur 2 zeigt eine vereinfachte Draufsicht einer unterschiedlich strukturierten Leiterbahn gemäß einem weiteren Stand der Technik, wie er beispielsweise aus der Literaturstelle Q.T. Jiang et al., Proceedings of 2001 IITC conference, Seiten 227 bis 229 bekannt ist. Gemäß dieser Druckschrift wurde die in Figur 2 dargestellte strukturabhängige Rekristallisation übergangsweise festgestellt, wobei in feinstrukturierten Bereichen mit beispielsweise einer Strukturbreite w1 im Gegensatz zu grob strukturierten Bereichen mit einer Strukturbreite w2 eine metallhaltige Schicht mit unterschiedlichen Korngrößen 5' und 5'' ausgebildet wird. Hierbei weisen die fein strukturierten Bereiche mit einer Breite wl auf Grund ihrer geringeren Korngröße einen wesentlich größeren Widerstand auf als die grob strukturierten Bereiche mit ihren großen Korngrößen. Nachteilig ist jedoch bei einer derartigen Herstellung von dünnen metallhaltigen Schichten ein mit der Damascene-Technologie einhergehender hoher Aufwand sowie eine für ein Ausheilen auch in den fein strukturierten Bereichen relativ hohe Temperatur und Zeitbedarf, wodurch sich Verschlechterungen der elektrischen Eigenschaften der Halbleiterbauelemente sowie Elektromigrationsprobleme ergeben können. In den fein strukturierten Bereichen lassen sich auch bei höherer Ausheiltemperatur und bei längerer Zeit nicht dieselben großen Korngrössen erzeugen wie in den grob strukturierten Bereichen, da die maximale Korngrösse im wesentlichen durch die Geometrie der zu füllenden Strukturen begrenzt ist.

Der Erfindung liegt daher die Aufgabe zu Grunde ein Verfahren zur Herstellung dünner metallhaltiger Schichten mit geringem elektrischen Widerstand zu schaffen, welches einfach und kostengünstig zu realisieren ist. Ferner liegt der Erfindung die Aufgabe zu Grunde dünne metallhaltige Schichten mit verbesserten Elektromigrationseigenschaften herzustellen.

Erfindungsgemäß wird diese Aufgabe durch die Maßnahmen des Patentanspruchs 1 gelöst.

Insbesondere durch das ganzflächige Ausbilden einer metallhaltigen Schicht mit einer ersten Korngröße bis zu einer ersten Dicke, einem nachfolgenden Durchführen einer Rekristallisation bei dieser Dicke, einem anschließenden Dünnen der metallhaltigen Schicht auf eine gewünschte Zieldicke und abschließendem fotolithographischem Strukturieren erhält man auch bei Zieldicken von weit unterhalb 0,2 Mikrometern ausreichend große Korngrößen, wodurch sowohl verbesserte Leitfähigkeiten als auch Elektromigrationseigenschaften realisiert werden können.

Zur Realisierung einer strukturierten metallhaltigen Schicht wird dabei die dünne metallhaltige Schicht mit herkömmlichen Verfahren strukturiert, wobei insbesondere ein RIE-Ätzverfahren oder Verfahren mit auf Chlor basierten Ätzchemikalien bei einer Temperatur von 180 bis 300 Grad Celsius verwendet werden kann. Hierdurch können auch üblicherweise schwer ätzbare Materialien wie Kupfer, Silber oder eventuell Gold ausreichend fein strukturiert werden.

Vorzugsweise wird die Rekristallisationsdicke auf eine Dicke größer 0,3 Mikrometer eingestellt, wodurch man auf besonders einfache und schnelle Weise eine Rekristallisation zu ausreichend großen Korngrößen in der metallhaltigen Schicht erhält.

Insbesondere bei Verwendung in integrierten Halbleiterschaltungen kann das Trägermaterial eine Diffusionsbarrierenschicht aufweisen, wodurch eine unerwünschte Diffusion von Stoffen der metallhaltigen Schicht in die Halbleiterbauelemente und insbesondere in ein dazugehöriges Halbleitersubstrat zuverlässig verhindert wird und somit die elektrischen Eigenschaften der Halbleiterbauelemente unbeeinflusst bleiben.

Ferner kann das Trägermaterial eine sehr dünne Keimschicht aufweisen, wodurch insbesondere ein elektrochemisches Abscheiden der metallhaltigen Schicht wesentlich vereinfacht wird. Neben einem derartigen ECD-Verfahren können jedoch auch herkömmliche CVD- oder PVD-Verfahren verwendet werden. Ferner können neben Metallen oder Legierungen auch sogenannte dotierte Metalle verwendet werden, wodurch sich die elektrischen Eigenschaften bzw. ein Rekristallisationsvermögen der metallhaltigen Schicht weiter verbessern lässt.

Insbesondere bei Verwendung von elektrochemisch abgeschiedenen metallhaltigen Schichten kann eine Rekristallisation durch Ausheilen bei Zimmertemperatur über mehrere Tage durchgeführt werden, wodurch sich der Aufwand sowie die Kosten wesentlich reduzieren lassen und insbesondere die elektrischen Eigenschaften in zugehörigen Halbleiterbauelementen unbeeinflusst bleiben. Alternativ kann jedoch auch ein Ausheilen in einem Temperaturbereich von 100 bis 400 Grad Celsius und in einem Zeitbereich von 10 bis 60 Minuten durchgeführt werden, wodurch weiterhin die elektrischen Eigenschaften der Halbleiterbauelemente im Wesentlichen unbeeinflusst bleiben und eine starke Beschleunigung bei der Herstellung ermöglicht wird.

Vorzugsweise wird hierbei eine Rekristallisation in einer Schutzgasatmosphäre mit Stickstoff, Argon oder in Vakuum durchgeführt, wodurch eine unerwünschte Oxidation der metallhaltigen Schicht zuverlässig verhindert werden kann.

Eine Zieldicke wird vorzugsweise auf eine Dicke kleiner 0,1 Mikrometer eingestellt wodurch sich bei einer nachfolgenden Strukturierung insbesondere elektro-magnetische bzw. kapazitive Kopplungsprobleme zwischen eng benachbarten Leiterbahnen stark verringern lassen. Auf diese Weise ist auch bei sehr kleinen Strukturgrößen bzw. Leiterbahnbreiten ein gewünschtes aspect ratio AR bzw. Höhen-Breiten-Verhältnis von kleiner als 2 bis 3 realisierbar.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnungen näher beschrieben.

### Es zeigen:

- Figuren 1a und 1b: vereinfachte Schnittansichten zur Veranschaulichung wesentlicher Herstellungsschritte in einem herkömmlichen Damascene-Verfahren;

- Figur 2: eine vereinfachte Draufsicht zur Veranschaulichung von strukturbedingten Rekristallisationseigenschaften gemäß dem Stand der Technik; und
- Figuren 3a bis 3d: vereinfachte Schnittansichten zur Veranschaulichung wesentlicher Verfahrensschritte bei der erfindungsgemäßen Herstellung dünner metallhaltiger Schichten.

Die Erfindung wird nachstehend anhand einer Cu-Schicht als metallhaltige Schicht beschrieben, wobei in gleicher Weise auch andere metallhaltige Schichten und insbesondere Al, Ag und/oder Au verwendet werden können. Derartige alternative Materialien zur Realisierung von Metallisierungsschichten gewinnen insbesondere in der Halbleitertechnik zunehmend an Bedeutung, da sie eine verbesserte Leitfähigkeit und somit erhöhte Taktraten sowie einen verringerten Leistungsverbrauch ermöglichen.

Insbesondere bei sehr kleinen Strukturgrößen von kleiner 0,1 Mikrometer (hinsichtlich ihrer Dicke oder Höhe) ergeben sich jedoch die Eingangs beschriebenen Probleme, wobei insbesondere auf Grund der sehr kleinen Korngrößen im elektrisch leitenden Material eine wesentliche Widerstandserhöhung einsetzt. Ferner führen derartige kleine Korngrößen zu einer verstärkten, jedoch unerwünschten Elektromigration in Richtung der jeweiligen Leiterbahnen. Auf diese Weise können die Vorteile derartiger neuer bzw. alternativer Verdrahtungsmaterialien verringert werden.

Das erfindungsgemäße Verfahren zeigt nunmehr, wie auf einfache Art und Weise auch für sehr kleine Strukturgrößen < 0,2µm verwendbare dünne metallhaltige Schichten mit geringem elektrischen Widerstand und verbesserten Elektromigrationseigenschaften hergestellt werden können.

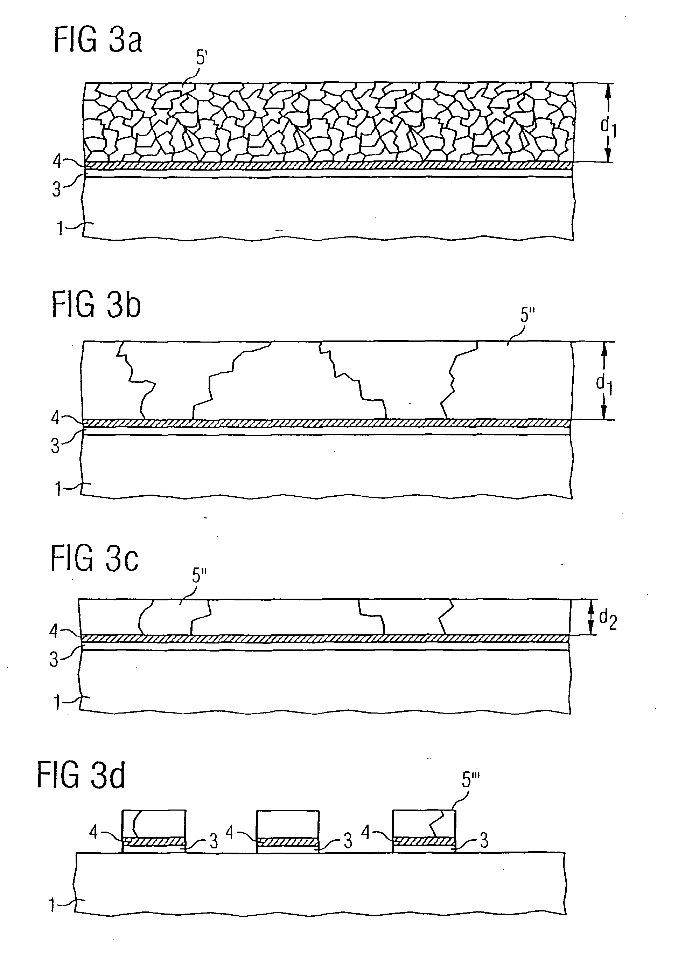

Gemäß Figur 3a wird zunächst beispielsweise auf einem Trägersubstrat 1, welches beispielsweise ein Halbleitersubstrat mit seinen zugehörigen darüber liegenden Elementschichten aufweist, zur Ausbildung beispielsweise einer ersten Metallisierungsschicht bzw. Verdrahtungsebene zunächst eine Diffusionsbarrierenschicht 3 ganzflächig ausgebildet. Eine derartige Diffusionsbarrierenschicht bzw. dieser sogenannte Liner 3 besteht beispielsweise aus Ta, TaN, TiN, WN oder vergleichbaren Materialien, die eine unerwünschte Diffusion von Stoffen einer darüber liegenden Schicht in die Halbleiterbauelemente bzw. ein Halbleitersubstrat des Trägersubstrats 1 zuverlässig verhindert. Falls eine derartige Diffusion unproblematisch ist, kann eine derartige Diffusionsbarrierenschicht 3 selbstverständlich auch entfallen.

Ferner befindet sich an der Oberfläche der Diffusionsbarrierenschicht 3 eine Keimschicht bzw. eine sogenannte seed layer 4, die beispielsweise aus dem gleichen Material besteht wie eine nachfolgend auszubildende eigentliche metallhaltige Schicht und im Wesentlichen einer-vereinfachten Ausbildung bzw. Abscheidung dient. Sowohl die Diffusionsbarrierenschicht 3 als auch die Keimschicht 4 werden beispielsweise durch ein PVD-Verfahren (physical vapor deposition) oder ein CVD-Verfahren (chemical vapor deposition) ausgebildet.

Vorzugsweise besteht im vorliegenden Ausführungsbeispiel die Keimschicht 4 aus einer Cu-Keimschicht, wodurch eine metallhaltige Cu-Schicht 5' mit einer ersten Korngröße bis zu einer wesentlich dicker als gewünschten ersten Dicke d1 auf dem Trägermaterial 1 bzw. der Diffusionsbarrierenschicht und der Keimschicht 4 ausgebildet wird. Wiederum kann dieses Ausbilden der metallhaltigen Schicht 5' mit seiner ersten sehr kleinen Korngröße mittels herkömmlicher PVD- oder CVD-Verfahren durchgeführt werden, wobei jedoch vorzugsweise ein galvanisches bzw. elektrochemisches Abscheideverfahren (ECD, Electro Chemical Deposition) verwendet wird. Hierbei wird die Keimschicht 4 als Aufwachselektrode für die metallhaltige Schicht 5' mit ihrer ersten Korngröße verwendet. Die Dicke d1 wird vorzugsweise auf eine Größe größer 0,3 Mikrometer eingestellt, wodurch insbesondere bei Verwendung von Kupfer eine für die Rekristallisation ausreichende Schichtdicke bereitgestellt wird. In gleicher Weise wie die Diffusionsbarrierenschicht 3 kann auch die Keimschicht 4 grundsätzlich entfallen, wodurch jedoch schlechtere Aufwachsbedingungen zu erwarten sind.

Alternativ zu den vorstehend beschriebenen Materialien für die metallhaltige Schicht wie Cu, Al, Ag oder Au können auch Legierungen oder sogenannte dotierte Metalle verwendet werden, wodurch sich je nach Bedarf verbesserte elektrische Eigenschaften oder eine vereinfachte Herstellung ergibt. Derartige dotierte Metalle sind beispielsweise AlCu mit 0,5 % Cu, AlSiCu mit 1 % Si und 0,5 % Cu, oder CuTi, CuIn, CuSn, CuMg, CuAl, CuZr, usw.

Gemäß Figur 3b wird nunmehr in einem nachfolgenden Schritt eine Rekristallisation der metallhaltigen Schicht 5' mit ihrer ersten kleinen Korngröße zum Erzeugen einer metallhaltigen Schicht 5" mit einer zur ersten Korngröße vergrößerten zweiten Korngröße bei unveränderter Dicke d1 durchgeführt.

Auf Grund der außerordentlich hohen Schichtdicke erfolgt einerseits bereits bei Zimmertemperatur und in einem Zeitraum von mehreren Tagen eine Rekristallisation der ersten (kleinen) Korngrößen zu der Dicke d1 entsprechenden vergrößerten zweiten Korngrößen. Auf Grund der nunmehr verringerten Anzahl von Korngrößen-Grenzübergängen wird die elektrische Leitfähigkeit der metallhaltigen Schicht wesentlich verbessert, wobei auch eine Elektromigration, die im Wesentlichen entlang dieser Korngrenzen stattfindet, wesentlich verringert ist. Darüber hinaus ist bei einem derartigen Ausheilvorgang bei Zimmertemperatur kein zusätzliches Equipment notwendig und eine Veränderung der elektrischen Eigenschaften von im Trägermaterial- bzw. Trägersubstrat 1 befindlichen Halbleiterbauelementen auf Grund von thermisch bedingter Ausdiffusion ausgeschlossen.

Vorzugsweise wird jedoch dieser Ausheilvorgang in einem Temperaturbereich von 100 Grad Celsius bis 400 Grad Celsius und in einem Zeitbereich von 10 bis 60 Minuten durchgeführt, wodurch man eine stark beschleunigte Herstellung dieser Schichten erhält und die elektrischen Eigenschaften von beispielsweise vorhandenen Halbleiterbauelementen weiterhin kaum verschlechtert werden. Beispielsweise wird ein derartiges Ausheilen in einer Schutzgasatmosphäre aus N₂, Ar, oder in einem Vakuum durchgeführt. Es können jedoch auch alternative Bedingungen eingestellt werden, bei denen eine Oxidation der metallhaltigen Schicht im Wesentlichen verhindert wird.

Gemäß Figur 3c wird in einem nachfolgenden Verfahrensschritt die metallhaltige Schicht 5" mit der zweiten, d.h. vergrößerten, Korngröße auf eine gewünschte Zieldicke d2 gedünnt, wobei vorzugsweise ein chemisch-mechanisches Polieren (CMP, chemical mechanical polishing) durchgeführt wird. Alternativ können jedoch auch Nass-Ätzverfahren, Trocken-Ätzverfahren und/oder Elektro-Polierverfahren durchgeführt werden, wobei in umgekehrter Weise zum elektrochemischen Abscheideverfahren die metallhaltige Schicht 5" durch elektrochemische Reaktionen vorzugsweise in einer Flüssigkeit wieder abgebaut wird.

Die Zieldicke d2 kann nunmehr auf Dicken kleiner 0,2 Mikrometer und vorzugsweise auf Dicken kleiner 0,1 Mikrometer eingestellt werden, wodurch man eine außerordentlich dünne planare Cu-Schicht 5" mit einer außerordentlich guten elektrischen Leitfähigkeit und mit stark verbesserten Elektromigrationseigenschaften erhält. Gemäß Figur 3c bleiben nämlich die Kornstrukturen bei diesem Dünnen im wesentlichen unverändert, so dass man eine erwünschte sogenannte Bambusstruktur in der metallhaltigen Schicht 5" erhält. Eine derartige Korngrößenstruktur könnte auch bei Verwendung von wesentlich höheren Ausheiltemperaturen nicht erreicht werden, wenn bereits zu Beginn lediglich eine metallhaltige Schicht mit der Zieldicke d2 abgeschieden wird.

Derartige dünne metallhaltige Schichten mit einer Dicke kleiner 0,1 Mikrometer haben insbesondere bei einer nachfolgenden Strukturierung Vorteile dahingehend, dass eine kapazitive Kopplung zwischen benachbarten Leiterbahnen wesentlich verringert ist. Zur Erreichung einer derart günstigen Unempfindlichkeit gegenüber kapazitiven oder elektromagnetischen Kopplungen benötigt man üblicherweise Dicken/Höhen-Verhältnisse von AR (aspect ratio) kleiner als 2 bis maximal 3, was bei höchstintegrierten Schaltungen zu den geforderten Schichtdicken < 0,1µm führt.

Figur 3d zeigt einen abschließenden Verfahrensschritt, wonach die dünne metallhaltige Schicht optional in gewünschte Leiterbahnen bzw. eine strukturierte metallhaltige Schicht 5'" strukturiert wird. Ein derartiges Strukturieren erfolgt beispielsweise mittels herkömmlicher RIE-Ätzverfahren (reactive ion etching), wobei vorher beispielsweise bekannte und daher nicht beschriebene fotolithographische Verfahren zur Maskierung durchgeführt werden. Bei gröberen Strukturen ist auch eine Strukturierung durch ein Naßätzverfahren möglich.

Insbesondere bei Verwendung von Kupfer für die metallhaltige Schicht kann ein aus der Literaturstelle Yan Ye et al., "Developement of Cu etch process for advanced Cu interconnects", Proceedings of 1998 IITC conference, Seiten 235 und 236 verwendet werden, wobei eine Strukturierung mit einer chlorbasierten Ätzchemikalie bei einer Temperatur von 180 Grad bis 300 Grad Celsius durchgeführt wird und dadurch die relativ schwer handhabbaren Cu-Schichten auf einfache und saubere Art und Weise strukturiert werden können.

Die Erfindung wurde vorstehend anhand einer Cu-Schicht als metallhaltige Schicht beschrieben, sie ist jedoch nicht darauf beschränkt und umfasst in gleicher Weise alternative metallhaltige Materialien, die bei unterschiedlichen Dicken unterschiedliche Rekristallisationseigenschaften aufweisen. In gleicher Weise ist die vorliegende Erfindung nicht auf ein Trägermaterial beschränkt, welches eine Halbleiterschaltung beinhaltet, sondern kann in gleicher Weise auf beliebigen anderen Trägersubstraten ausgebildet werden, auf denen eine sehr dünne elektrisch leitende Schicht mit geringem elektrischen Widerstand ausgebildet werden soll. In gleicher Weise sind die Rekristallisationsdicke sowie die Zieldicke lediglich beispielhaft für eine Cu-Schicht genannt, wobei andere Materialien grundsätzlich auch andere Dicken und insbesondere eine alternative Rekristallisationsdicke benötigen können.

## Patentansprüche

1. Verfahren zur Herstellung dünner metallhaltiger Schichten mit geringem elektrischen Widerstand mit den Schritten:
a) Ganzflächiges Ausbilden einer metallhaltigen Schicht (5') mit einer ersten Korngröße bis zu einer ersten Dicke (d1) auf einem Trägermaterial (1, 3, 4);
b) Durchführen einer Rekristallisation der ganzflächigen metallhaltigen Schicht (5") zum Erzeugen einer ganzflächigen metallhaltigen Schicht (5") mit einer zur ersten Korngröße vergrößerten zweiten Korngröße bei der ersten Dicke (d1);
c) Dünnen der ganzflächigen metallhaltigen Schicht (5") mit der zweiten Korngröße zum Erzeugen einer ganzflächigen metallhaltigen Schicht (5") mit einer gewünschten Zieldicke (d2); und
d) fotolithographisches Strukturieren der gedünnten ganzflächigen metallhaltigen Schicht (5") mit der zweiten Korngröße zum Erzeugen einer strukturierten metallhaltigen Schicht (5"').

2. Verfahren nach Patentanspruch 1,
**dadurch gekennzeichnet, dass** in Schritt
a) die erste Dicke (d1) auf einen Wert größer 0,3 Mikrometer eingestellt wird.

3. Verfahren nach einem der Patentansprüche 1 oder 2,
**dadurch gekennzeichnet, dass** in Schritt
a) das Trägermaterial eine Diffusionsbarrierenschicht (3) aufweist.

4. Verfahren nach einem der Patentansprüche 1 bis 3,
**dadurch gekennzeichnet, dass** in Schritt
a) das Trägermaterial eine Keimschicht (4) aufweist.

5. Verfahren nach einem der Patentansprüche 1 bis 4,
**dadurch gekennzeichnet, dass** in Schritt
d) auch die Keimschicht (4) und die Diffusionsbarrierenschicht (3) strukturiert wird.

6. Verfahren nach einem der Patentansprüche 1 bis 5,
**dadurch gekennzeichnet, dass** in Schritt
a) ein CVD-, PVD- und/oder ECD-Verfahren durchgeführt wird.

7. Verfahren nach einem der Patentansprüche 1 bis 6,
**dadurch gekennzeichnet, dass** in Schritt
a) zum Ausbilden der ganzflächigen metallhaltigen Schicht (5') Cu, Al, Ag und/oder Au verwendet wird.

8. Verfahren nach einem der Patentansprüche 1 bis 7,
**dadurch gekennzeichnet, dass** in Schritt
a) zum Ausbilden der ganzflächigen metallhaltigen Schicht (5) dotierte Metalle verwendet werden.

9. Verfahren nach einem der Patentansprüche 1 bis 8,
**dadurch gekennzeichnet, dass** in Schritt
b) ein Ausheilen bei Zimmertemperatur über mehrere Tage durchgeführt wird.

10. Verfahren nach einem der Patentansprüche 1 bis 8,
**dadurch gekennzeichnet, dass** in Schritt
b) ein Ausheilen in einem Temperaturbereich von 100 Grad Celsius bis 400 Grad Celsius und einem Zeitbereich von 10 bis 60 Minuten durchgeführt wird.

11. Verfahren nach einem der Patentansprüche 1 bis 10,
**dadurch gekennzeichnet, dass** in Schritt
b) die Rekristallisation in einer Schutzgasatmosphäre durchgeführt wird.

12. Verfahren nach einem der Patentansprüche 1 bis 11,
**dadurch gekennzeichnet, dass** in Schritt
c) die Zieldicke (d2) auf einen Wert kleiner 0,1 Mikrometer eingestellt wird.

13. Verfahren nach einem der Patentansprüche 1 bis 12,
**dadurch gekennzeichnet, dass** in Schritt
c) ein CMP-, Trockenätz-, Nassätz- und/oder Elektropolier-Verfahren durchgeführt wird.

14. Verfahren nach einem der Patentansprüche 2 bis 13,
**dadurch gekennzeichnet, dass** in Schritt
d) ein RIE-Ätzverfahren durchgeführt wird.

15. Verfahren nach einem der Patentansprüche 2 bis 14,
**dadurch gekennzeichnet, dass** in Schritt
d) eine chlorbasierte Ätzchemikalie bei einer Temperatur von 180 Grad Celsius bis 300 Grad Celsius verwendet wird.

16. Verfahren nach einem der Patentansprüche 2 bis 14,
**dadurch gekennzeichnet, dass** in Schritt
d) eine nasschemische Ätzung verwendet wird.

## Claims

1. Process for producing metal-containing thin films with a low electrical resistance, comprising the steps of:
a) forming a metal-containing layer (5') with a first grain size up to a first thickness (d1) on the entire surface of a substrate material (1, 3, 4);
b) carrying out a recrystallization of the metal-containing layer (5') which covers the entire surface to produce a metal-containing layer (5") with a second grain size, which is greater than the first grain size, which covers the entire surface at the first thickness (d1);
c) thinning the metal-containing layer (5") with the second grain size which covers the entire surface to produce a metal-containing layer (5") which covers the entire surface having a desired target thickness (d2); and
d) photolithographically structuring the metal-containing thinned layer (5") with the second grain size which covers the entire layer to produce a structured metal-containing layer (5"').

2. Process according to Patent Claim 1, **characterized in that** in step a) the first thickness (d1) is set to a value of greater than 0.3 micrometer.

3. Process according to either of Patent Claims 1 and 2, **characterized in that** in step a) the substrate material has a diffusion barrier layer (3).

4. Process according to one of Patent Claims 1 to 3, **characterized in that** in step a) the substrate material has a seed layer (4).

5. Process according to one of Patent Claims 1 to 4, **characterized in that** in step d) the seed layer (4) and the diffusion barrier layer (3) are also structured.

6. Process according to one of Patent Claims 1 to 5, **characterized in that** in step a) a CVD, PVD and/or ECD process is carried out.

7. Process according to one of Patent Claims 1 to 6, **characterized in that** in step a) Cu, Al, Ag and/or Au is used to form the metal-containing layer (5') which covers the entire area.

8. Process according to one of Patent Claims 1 to 7, **characterized in that** in step a) doped metals are used to form the metal-containing layer (5') which covers the entire area.

9. Process according to one of Patent Claims 1 to 8, **characterized in that** in step b) an anneal is carried out at room temperature for several days.

10. Process according to one of Patent Claims 1 to 8, **characterized in that** in step b) an anneal is carried out in a temperature range from 100 degrees Celsius to 400 degrees Celsius over a period of 10 to 60 minutes.

11. Process according to one of Patent Claims 1 to 10, **characterized in that** in step b) the recrystallization is carried out in a shielding-gas atmosphere.

12. Process according to one of Patent Claims 1 to 11, **characterized in that** in step c) the target thickness (d2) is set to a value of less than 0.1 micrometer.

13. Process according to one of Patent Claims 1 to 12, **characterized in that** in step c) a CMP, dry-etching, wet-etching and/or electropolishing process is carried out.

14. Process according to one of Patent Claims 2 to 13, **characterized in that** in step d) an RIE process is carried out.

15. Process according to one of Patent Claims 2 to 14, **characterized in that** in step d) a chlorine-based etching chemical is used at a temperature of from 180 degrees Celsius to 300 degrees Celsius.

16. Process according to one of Patent Claims 2 to 14, **characterized in that** in step d) a wet-chemical etch is used.

## Revendications

1. Procédé de production de minces couches contenant du métal ayant une résistance petite, dans lequel :
a) on forme sur toute la surface une couche (5') contenant du métal ayant une première granulométrie jusqu'à une première épaisseur (d1) sur un matériau (1, 3, 4) support ;
b) on effectue une recristallisation de la couche (5') contenant du métal sur toute la surface pour la production d'une couche (5") contenant du métal sur toute la surface ayant une deuxième granulométrie plus grande que la première granulométrie à la première épaisseur (d1) ;
c) on amincie la couche (5") contenant du métal sur toute la surface ayant la deuxième granulométrie pour produire une couche (5") contenant du métal sur toute la surface ayant une épaisseur (d2) visée souhaitée ; et
d) on structure par photolithographie la couche (5") contenant du métal sur toute la surface qui a été amincie et qui a la deuxième granulométrie pour produire une couche (5"') contenant du métal structurée.

2. Procédé selon la revendication 1,
**caractérisé en ce qu'**au stade a) on règle la première épaisseur (d1) à une valeur plus grande que 0,3 micron.

3. Procédé suivant l'une des revendications 1 ou 2,
**caractérisé en ce qu'**au stade a) le matériau support a une couche (3) formant barrière à la diffusion.

4. Procédé selon l'une des revendications 1 à 3,
**caractérisé en ce qu'**au stade a) le matériau formant support a une couche (4) de germe.

5. Procédé suivant l'une des revendications 1 à 4,
**caractérisé en ce qu'**au stade d) on structure aussi la couche (4) de germe et la couche (3) formant barrière à la diffusion.

6. Procédé suivant l'une des revendications 1 à 5,
**caractérisé en ce qu'**au stade a) on effectue un procédé CVD, PVD et/ou ECD.

7. Procédé suivant l'une des revendications 1 à 6,
**caractérisé en ce qu'**au stade a) on utilise Cu, Al, Ag et/ou Au pour former la couche (5') contenant du métal sur toute la surface.

8. Procédé selon l'une des revendications 1 à 7,
**caractérisé en ce qu'**au stade a) on utilise des métaux dopés pour former la couche (5') contenant du métal sur toute la surface.

9. Procédé selon l'une des revendications 1 à 8,
**caractérisé en ce qu'**au stade b) on effectue un revenu à la température ambiante pendant plusieurs jours.

10. Procédé selon l'une des revendications 1 à 8,
**caractérisé en ce qu'**au stade b) on effectue un revenu dans une plage de température de 100°C à 400°C et pendant à laps de temps de 10 à 60 minutes.

11. Procédé selon l'une des revendications 1 à 10,
**caractérisé en ce qu'**au stade b) on effectue la recristallisation dans une atmosphère de gaz de protection.

12. Procédé selon l'une des revendications 1 à 11,
**caractérisé en ce qu'**au stade c) on règle l'épaisseur (d2) visée à une valeur plus petite à 0,1 micro.

13. Procédé selon l'une des revendications 1 à 12,
**caractérisé en ce qu'**au stade c) on effectue un procédé CMP, d'attaque à sec, d'attaque en voie humide et/ou d'électropolissage.

14. Procédé selon l'une des revendications 2 à 13,
**caractérisé en ce qu'**au stade d) on effectue un procédé d'attaque RIE.

15. Procédé selon l'une des revendications 1 à 14,
**caractérisé en ce qu'**au stade d) on utilise un produit chimique d'attaque à base de chlore à une température de 180°C à 300°C.

16. Procédé selon l'une des revendications 2 à 14,
**caractérisé en ce qu'**au stade d) on utilise une attache chimique en voie humide.
